Europäisches Patentamt

European Patent Office

Office européen des brevets

(11) Veröffentlichungsnummer: **0 141 088**
**A2**

## (12) EUROPÄISCHE PATENTANMELDUNG

(21) Anmeldenummer: **84109644.9**

(22) Anmeldetag: **13.08.84**

(51) Int. Cl.⁴: **H 01 L 29/08**

(30) Priorität: **19.08.83 DE 3330011**

(43) Veröffentlichungstag der Anmeldung:
**15.05.85 Patentblatt 85/20**

(84) Benannte Vertragsstaaten:
**DE FR GB SE**

(71) Anmelder: **Siemens Aktiengesellschaft**
**Berlin und München Wittelsbacherplatz 2**
**D-8000 München 2(DE)**

(72) Erfinder: **Schmitt-Landsiedel, Doris Dipl.-Ing. Dipl.-Phys.**
**Metzstrasse 25**
**D-8000 München 80(DE)**

(72) Erfinder: **Dorda, Gerhard, Dr.**
**Triester Strasse 11**
**D-8000 München 80(DE)**

(54) **Halbleiter-Bauelement mit einem Heisse-Elektronen-Transistor.**

(57) Halbleiter-Bauelement mit einem Heiße-Elektronen-Transistor des Tunnelemissionstyps, der eine Emitterschicht, eine erste Isolatorschicht, eine metallische oder metallisch leitende Basisschicht und eine Kollektorschicht aufweist. Angestrebt wird eine Ausgestaltung des Bauelements, die in einfacher Weise herstellbar ist. Das wird dadurch erreicht, daß die Emitterschicht aus einer Inversionsschicht (16) besteht, die im Kanalbereich (4) eines auf einem Halbleiterkörper (1) integrierten Feldeffekttransistors zwischen dessen Source- und Draingebiet (2, 3) aufgebaut ist, wobei die Basisschicht (5) wenigstens einen Teil der Gateelektrode des Feldeffekttransistors darstellt und die Kollektorschicht aus einer metallischen oder metallisch leitenden Schicht (8) und einer zwischen dieser und der Bassisschicht (5) befindlichen, zweiten Isolatorschicht (7) besteht. Der Anwendungsbereich umfaßt hochintegrierte Schaltkreise.

FIG 1

EP 0 141 088 A2

**0141088**

SIEMENS AKTIENGESELLSCHAFT
Berlin und München

Unser Zeichen
VPA 83 P 1 6 0 9 E

Halbleiter-Bauelement mit einem Heiße-Elektronen-Transistor

Die Erfindung bezieht sich auf ein Halbleiter-Bauelement mit einem Heiße-Elektronen-Transistor des Tunnelemissionstyps nach dem Oberbegriff des Patentanspruchs 1 und auf Verfahren zu seinem Betrieb.

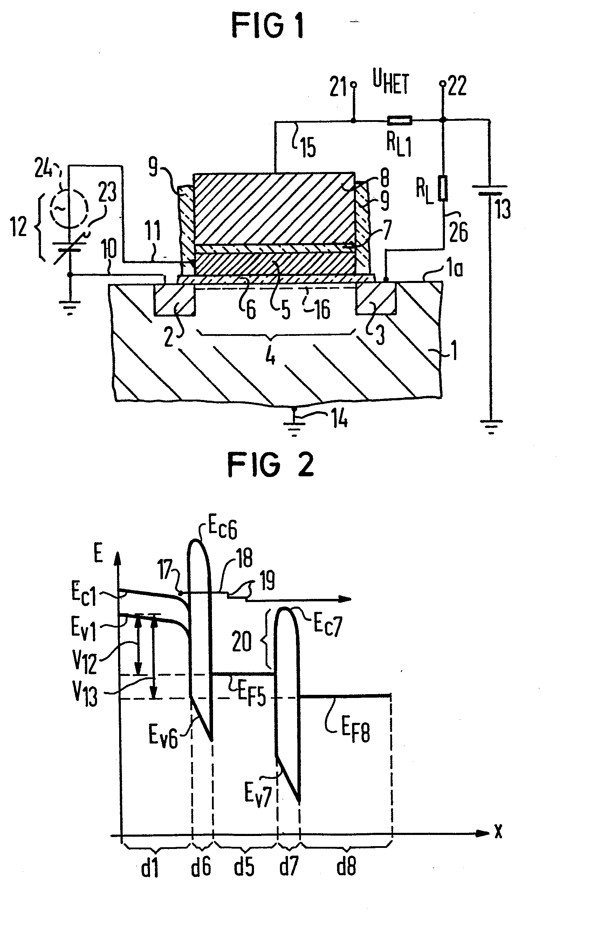

Ein solcher Heiße-Elektronen-Transistor ist aus der Zeitschrift "Solid State Electronics", Bd. 24, 1981, S.343 - 366, insbesondere Fig. 1 auf Seite 344, bekannt.

Der Erfindung liegt die Aufgabe zugrunde, ein Bauelement der eingangs genannten Art anzugeben, das in einfacher Weise hergestellt werden kann. Die Aufgabe wird erfindungsgemäß durch eine Ausbildung des Bauelementes nach dem kennzeichnenden Teil des Patentanspruchs 1 gelöst.

Das Halbleiter-Bauelement nach der Erfindung zeichnet sich insbesondere dadurch aus, daß der Heiße-Elektronen-Transistor (HET) in einfacher Weise monolithisch integrierbar ist, da seine Emitterschicht aus der Inversionsschicht eines auf einem Halbleiterkörper angeordneten Feldeffekttransistors besteht und die weiteren Schichten des HET oberhalb des Kanalbereichs des Feldeffekttransistors und somit außerhalb des Halbleiterkörpers angeordnet sind. Die Basisschicht des HET überdeckt dabei wenigstens einen Teil des Kanalbereichs und stellt insoweit gleichzeitig die Gateelektrode des Feldeffekttransistors dar.

Die Ansprüche 2 bis 15 sind auf bevorzugte Weiterbildungen und Ausgestaltungen der Erfindung gerichtet, während

St 1 Sti/29.6.1983

die Ansprüche 16 bis 20 vorteilhafte Verfahren zum Betrieb des Halbleiter-Bauelements nach der Erfindung betreffen.

Die Erfindung wird nachfolgend anhand der Zeichnung näher erläutert. Dabei zeigt:

Fig. 1 den Querschnitt eines ersten Ausführungsbeispiels,

Fig. 2 ein energetisches Bandstrukturschema zur Erläuterung der Fig. 1 und

Fig. 3 den Querschnitt eines zweiten Ausführungsbeispiels.

Ein in Fig. 1 dargestelltes, nach der Erfindung ausgebildetes Halbleiter-Bauelement weist einen Körper 1 aus dotiertem Halbleitermaterial, z.B. aus p-dotiertem Silizium mit einer Störstellenkonzentration von etwa $10^{15}/cm^3$, auf, in den zwei von einer Grenzfläche 1a ausgehende, z.B. $n^+$-dotierte, Gebiete 2 und 3 eingefügt sind. Diese stellen das Sourcegebiet und das Draingebiet eines Feldeffekttransistors dar, dessen Gateelektrode aus einer metallischen bzw. metallisch leitenden Schicht 5 gebildet ist, die den zwischen 2 und 3 liegenden Kanalbereich 4 überdeckt. Zwischen der Schicht 5 und der Grenzfläche 1a liegt dabei eine sehr dünne erste Isolatorschicht 6. Die Dicke der z.B. aus $SiO_2$ oder $Si_3N_4$ bestehenden ersten Isolatorschicht 6 beträgt zweckmäßigerweise etwa 2 bis 5 nm. Die Schicht 5 besteht mit Vorteil aus einem hochschmelzenden Metall, z.B. aus Ta, Ti oder Mo oder W, oder aus dem Silizid eines dieser Metalle, d.h. aus $TaSi_2$, $TiSi_2$, $MoSi_2$ oder $WSi_2$, und kann eine Dicke von etwa 10 nm aufweisen. Oberhalb der metallischen Schicht 5 befindet sich eine zweite Isolatorschicht 7, z.B. aus $SiO_2$ oder $Si_3N_4$, mit einer Dicke von etwa 2 bis 5 nm.

Auf der Schicht 7 befindet sich eine metallische bzw. metallisch leitende Schicht 8, deren Dicke beliebig gewählt sein kann, zweckmäßigerweise jedoch etwa 1 µm beträgt. Die Schicht 8 besteht dabei mit Vorteil aus einem der Metalle oder Silizide, die bereits im Zusammenhang mit der Schicht 5 genannt worden sind. Eine die Oberfläche 1a außerhalb der Bereiche der Teile 2 bis 4 abdeckende elektrisch isolierende Schicht (Feldoxidschicht) weist an die Schichten 5, 7 und 8 lateral angrenzende Teile 9 auf.

Das Sourcegebiet 2 und die metallische Schicht 5 sind mit Anschlußleitungen 10, 11 versehen, die mit den Polen einer Spannungsquelle 12 verbunden sind, welche die metallische Schicht 5 auf ein gegenüber dem Sourcegebiet 2 positives Potential legt. Die Anschlußleitung 10 liegt ferner auf Massepotential. Das Draingebiet 3 ist über eine Anschlußleitung 26 und einen Lastwiderstand $R_L$ mit dem positiven Pol einer Spannungsquelle 13 verbunden, deren negativer Pol mit Massepotential beschaltet ist. Weiterhin ist der Halbleiterkörper über einen Anschluß 14 auf Massepotential gelegt. Die metallische Schicht 8 ist mit einer Anschlußleitung 15 versehen, die an den positiven Pol der Spannungsquelle 13 geführt ist. Dabei ist in die Anschlußleitung 15 ein Lastwiderstand $R_{L1}$ eingefügt.

Erhält die aus der Schicht 5 bestehende Gateelektrode des Feldeffekttransistors aus der Spannungsquelle 12 eine Spannung zugeführt, die oberhalb eines als erste Einsatzspannung bezeichneten Wertes liegt, so bildet sich im Halbleiterkörper 1 unterhalb von 5 eine von der Grenzfläche 1a ausgehende Verarmungszone zwischen den Gebieten 2 und 3 aus, wobei sich innerhalb dieser Verarmungszone unmittelbar an der Grenzfläche 1a eine Inversionsschicht 16 aufbaut, die einen n-leitenden Kanal zwischen den Gebieten 2 und 3 bildet.

Die Inversionsschicht 16 stellt die Emitterschicht eines
Heiße-Elektronen-Transistors (HET) des Tunnelemissionstyps dar, der zusätzlich die Schichten 6, 5, 7 und 8
aufweist. Dabei bildet die Schicht 5 eine metallische
Basisschicht des HET, wobei sich die erste Isolatorschicht 6 zwischen der Schicht 5 und der Emitterschicht
16 befindet, während die zweite Isolatorschicht 7 zusammen mit der metallischen Schicht 8 die Kollektorschicht des HET darstellt. 12 stellt für den HET eine
Basis-Emitter-Spannungsquelle dar, 13 eine Kollektor-
Spannungsquelle.

Die Funktion des HET sei nachfolgend anhand des in
Fig. 2 dargestellten energetischen Bandstrukturschemas
erläutert. Dieses zeigt in Richtung der vertikalen Achse
aufgetragene Energiezustände E, die in Abhängigkeit von
verschiedenen Entfernungen x von der Inversionsschicht
bzw. Emitterschicht 16 auftreten. Diese Entfernungen
sind auf einer Achse x aufgetragen, die in Fig. 1 die
Schichten des HET in vertikaler Richtung, d.h. senkrecht
zur Grenzfläche 1a, durchdringt. Den Schichten 16, 6, 5,
7 und 8 sind aufeinanderfolgende Abschnitte der x-Achse
zugeordnet, wobei aus Gründen einer deutlichen Darstellung die Längen d16, d6, d5, d7 und d8 dieser Abschnitte
von den tatsächlichen Schichtdicken D16, D6, D5, D7 und
D8 der Schichten 16, 6, 5, 7 und 8 abweichen. So sind
z. B. die Abschnitte d6 und d7 gegenüber den Abschnitten
d5, d8 und d16 stark gedehnt. In dem der Inversionsschicht 16 zugeordneten Abschnitt d16 ist die obere
Grenze des Valenzbandes des Halbleitermaterials von 1
mit $E_{v1}$ bezeichnet, während $E_{c1}$ das Energieniveau der
Elektronen innerhalb der Inversionsschicht 16 darstellt.
Im Abschnitt d6 stellt die obere Linie $E_{c6}$ die untere
Begrenzung des Leitungsbandes der Isolatorschicht 6 dar,
während die untere Linie $E_{v6}$ die obere Grenze des Valenzbandes bedeutet. In den Abschnitten d5 und d8 sind die jeweiligen Fermi-Niveaus $E_{F5}$ und $E_{F8}$ eingetragen, während im Abschnitt d7 die untere Grenze des Leitungsbandes der Isolatorschicht 7 durch $E_{c7}$ und die obere Grenze des Valenzbandes durch $E_{v7}$ dargestellt werden. Bei einer hinreichend kleinen Dicke D6 der ersten Isolatorschicht 6 gelangen Elektronen aus der Inversionsschicht 16, die in Fig. 2 gemäß ihrem Energieniveau z.B. durch den Punkt 17 gekennzeichnet sind, infolge des Tunneleffekts durch die Isolatorschicht 6 in die metallische Basisschicht 5, wie durch die horizontale Gerade 18 angedeutet wird. Durch Streuung an Fehlstellen und am Kristallgitter der Schicht 5 verlieren sie an Energie, was durch den treppenförmigen Verlauf 19 ausgedrückt wird. Ist die Energie dieser Elektronen danach noch so groß, daß sie die Energieschwelle 20 an der Grenzfläche zwischen den Schichten 5 und 7 überwinden können, so gelangen sie in die aus den Schichten 7 und 8 bestehende Kollektorschicht des HET. Die Größe der von den Spannungsquellen 12 und 13 abgegebenen Spannungen $V_{12}$ und $V_{13}$ ist in Fig. 2 ebenfalls eingezeichnet.

Die aus der Inversionsschicht bzw. Emitterschicht 16 stammenden Elektronen, die die Schicht 8 erreichen, führen zu einem Strom in der Kollektoranschlußleitung 15, der am Lastwiderstand $R_{L1}$ einen Spannungsabfall $U_{HET}$ erzeugt, welcher an Anschlüssen 21, 22 abgreifbar ist.

Nach einer ersten vorteilhaften Betriebsweise des Halbleiter-Bauelements nach Fig. 1 wird die Spannungsquelle 12 zwischen zwei Werten $V_{12}'$ und $V_{12}''$ umgeschaltet, was durch das Symbol 23 angedeutet ist. Dabei wird bei einer Umschaltung auf den größeren Wert $V_{12}'$, der oberhalb der ersten Einsatzspannung des Feldeffekttransistors liegt, die Isolatorschicht 6 von einem Tunnelstrom durchflossen, der den genannten Spannungsabfall $U_{HET}$ entstehen läßt. Die Umschaltung auf den kleineren Wert $V_{12}''$ bewirkt

eine wesentliche Verringerung bzw. Abschaltung der Spannung $U_{HET}$, insbesondere bei einem sehr kleinen Spannungswert $V_{12}''$, der nur geringfügig größer oder kleiner als die erste Einsatzspannung ist. Letzteres kann selbstverständlich auch erreicht werden, wenn die von 12 abgegebene Spannung vollständig abgeschaltet wird.

Nach einer zweiten vorteilhaften Betriebsweise wird die Spannungsquelle 12 auf einen Wert $V_{12}'''$ eingestellt, der oberhalb der ersten Einsatzspannung des Feldeffekttransistors liegt. Hiervon ausgehend wird die von 12 abgegebene Spannung in Abhängigkeit von einem Eingangssignal verändert, was in Fig. 1 durch eine gestrichelt gezeichnete Signalspannungsquelle 24 angedeutet ist. Dabei erfahren der Tunnelstrom und in weiterer Folge auch $U_{HET}$ entsprechende Änderungen, wobei die Änderungen von $U_{HET}$ von den Amplitudenänderungen des von 24 gelieferten Eingangssignals abhängen und insbesondere diesen gegenüber verstärkt sind.

Die vorstehend genannten Betriebsverfahren, für die die Spannungsquelle 13 jeweils einen festen Spannungswert abgibt, können mit folgenden konkreten Spannungswerten durchgeführt werden: Bei einer Spannung $V_{13}$ von etwa 5 V, von der für den Feldeffekttransistor 2 bis 6 eine Drainspannung abgeleitet wird, während sie für den HET 16, 6, 5, 7, 8 als Kollektor-Emitter-Spannung aufzufassen ist, wird der Feldeffekttransistor z.B. durch Einstellung von $V_{12}$ auf 1 V in den leitenden Zustand geschaltet, bei dem die Inversionsschicht 16 aufgebaut ist. Dabei ist jedoch der die Isolatorschicht 6 durchfließende Tunnelstrom noch vernachlässigbar klein. Bei einer Erhöhung von $V_{12}$ auf 2 V oder mehr steigt dieser Tunnelstrom $J_{BE}$ nach einer exponentiellen Funktion, deren Exponent dem Ausdruck $-\frac{1}{V_{12}}$ proportional ist, um einige Größenordnungen an.

Im Falle des Einschaltens einer Signalspannungsquelle 24 kann in der Spannungsquelle 12 eine feste Vorspannung $V_{12}'''$ von etwa 2 V eingestellt werden, die dann durch das von 24 gelieferte Eingangssignal verändert wird.

Ein über die Spannungsquelle 24 eingegebenes Eingangssignal $U_e$ kann Frequenzen bis zu über $10^{12}$ Hz aufweisen. Die gleiche Frequenzgrenze gilt auch für die Schaltfrequenzen, die bei einem fortwährenden Umschalten der Spannungsquelle 12 zwischen zwei Spannungswerten beherrscht werden können. Dabei kann man Verstärkungsfaktoren $\Delta U_{HET}/\Delta U_e$ von etwa 10 erhalten. $\Delta U_{HET}$ bezeichnet hierbei die Änderung von $U_{HET}$, die durch die Änderung $\Delta U_e$ von $U_e$ verursacht wird. Die lateralen Flächenabmessungen der Schichten 16, 6, 5, 7 und 8 betragen z.B. 1 $\mu m^2$, können aber auch größer gewählt werden, um den Tunnelstrom und die übertragbare Leistung zu erhöhen.

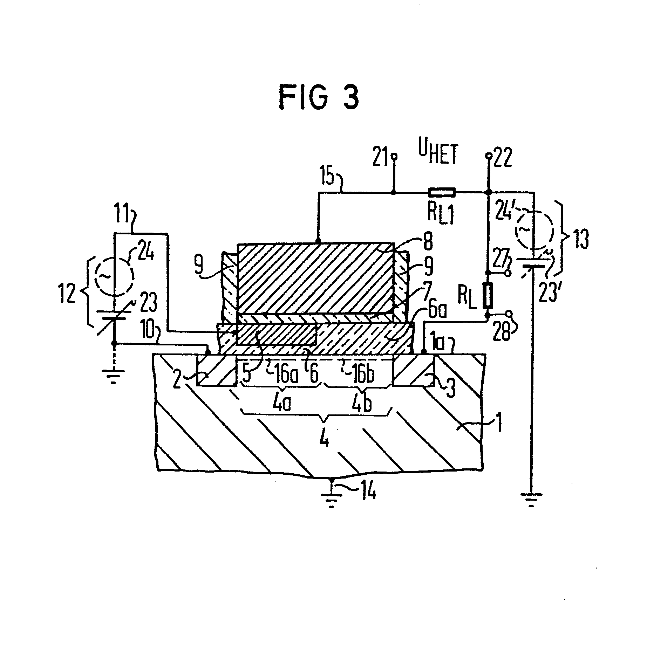

In Fig. 3 ist ein zweites Halbleiter-Bauelement nach der Erfindung gezeigt, das sich von Fig. 1 dadurch unterscheidet, daß die metallische bzw. metallisch leitende Schicht 5 nur einen ersten, an das Sourcegebiet 2 angrenzenden Teil 4a des Kanalbereichs 4 als Gateelektrode überdeckt. Der restliche Teil 4b wird von dem in Fig. 3 rechten Teil der Schicht 8 als Gateelektrode überdeckt. Zwischen dem rechten Teil der Schichten 7 und 8, die zusammen die Kollektorschicht des HET bilden, und der Grenzfläche 1a des Halbleiterkörpers befindet sich ein Teil 6a der Isolatorschicht 6, der eine größere Dicke von z.B. 20 nm aufweist als der Teil von 6, der sich oberhalb von 4a befindet. Der Teil 4b des Kanalbereiches weist eine zweite Einsatzspannung auf, die größer ist als die für den Teil 4a geltende, erste Einsatzspannung.

Führt man nun der Schicht 8 aus der Spannungsquelle 13 eine Spannung $V_{13}'$ zu, die an der Schicht 5 eine oberhalb der ersten Einsatzspannung liegende Gatespannung entstehen läßt, so bildet sich eine Inversionsschicht 16a aus, die der Inversionsschicht 16 von Fig. 1 entspricht. Die Inversionsschicht 16a besteht aber nur im ersten Teil 4a des Kanalbereichs, wenn man voraussetzt, daß die an der Schicht 8 liegende Spannung die zweite Einsatzspannung nicht übersteigt. Die Spannungsquelle 12 ist hierbei auf einen festen Spannungswert von etwa 1 V eingestellt, wobei die Erdung der Anschlußleitung 10 entfernt wird. Die anhand von Fig. 1 erläuterte Umschaltung 23 der Spannungsquelle 12 wird ersetzt durch eine Umschaltung 23' von 13 zwischen $V_{13}'$ und einem Wert $V_{13}''$, der an 5 eine unterhalb oder knapp oberhalb der ersten Einsatzspannung liegende Gatespannung hervorruft. Die Signalspannungsquelle 24 wird weiterhin durch eine entsprechende Signalspannungsquelle 24' ersetzt. Beide bereits anhand von Fig. 1 erläuterten Betriebsweisen werden dann mittels einer Steuerung der Spannungsquelle 13 durchgeführt, die analog zur Steuerung der Spannungsquelle 12 in Fig. 1 erfolgt, wobei 24' einen Teil von 13 darstellt. Wenn nun in Erweiterung dieser Betriebsweisen der Schicht 8 ein zweiter Spannungswert $V_{13}'''$ zugeführt wird, bei dem die zweite Einsatzspannung des Teils 4b überschritten wird, bildet sich dort eine Inversionsschicht 16b aus, die in Fig. 3 strichpunktiert gezeichnet ist. Die Inversionsschichten 16a und 16b ergeben zusammen einen leitenden Kanal zwischen dem Sourcegebiet 2 und Draingebiet 3, so daß der Feldeffekttransistor stromführend wird. Der dabei die Verbindungsleitung 26 durchfließende Drainstrom erzeugt an $R_L$ einen Spannungsabfall $U_{MOS}$, der an den Anschlüssen 27 und 28 abgreifbar ist. Eine Umschaltung zwischen $V_{13}$'' bzw. $V_{13}$' und $V_{13}$''' bewirkt eine Ein- und Abschaltung von $U_{MOS}$.

Andererseits besteht auch die Möglichkeit, das Bauelement nach Fig. 3 über die (in diesem Falle wieder geerdete) Spannungsquelle 12 in der bereits beschriebenen Weise zu steuern, wobei die Zuführung von $V_{12}$' oder $V_{12}$''' jeweils den Aufbau der Inversionsschicht 16a zur Folge hat. Die Spannungsquelle 13 wird hierzu auf einen festen Wert von z.B. 3 V eingestellt, bei dem an der Schicht 8 die Einsatzspannung des Teils 4b des Kanalbereichs noch nicht erreicht ist. Führt man jedoch in Erweiterung dieser Betriebsweisen der Schicht 8 aus 13 die bereits definierte Spannung $V_{13}$''' zu, bei der die zweite Einsatzspannung von 4b überschritten wird, so bildet sich wieder eine Inversionsschicht 16b aus, die zusammen mit 16a einen leitenden Kanal zwischen 2 und 3 ergibt. Der hierdurch hervorgerufene, bei 27, 28 abgreifbare Spannungsabfall $U_{MOS}$ wird beim Zurückschalten der Spannungsquelle 13 von $V_{13}$''' auf den festen Wert von z.B. 3 V wieder abgeschaltet, ohne daß der über 12 gesteuerte Betrieb des HET hierdurch wesentlich beeinflußt wird.

Die Herstellung des Halbleiter-Bauelements nach Fig. 1 entspricht zunächst der üblichen Herstellung eines Feldeffekttransistors. Nachdem eine den Halbleiterkörper ganzflächig bedeckende Feldoxidschicht 9 oberhalb des Kanalbereichs 4 und oberhalb der Gebiete 2 und 3 weggeätzt und in dem weggeätzten Bereich die erste Isolatorschicht 6 thermisch aufgewachsen wurde, wird eine großflächige Maske auf der so entstandenen Struktur angebracht, die eine die lateralen Abmessungen der Schichten 5, 7 und 8 definierende Öffnung enthält. Unter Anwendung diese Maske werden dann die Schicht 5, die zweite Isolatorschicht 7 und die Schicht 8 nacheinander aufgebracht. Nach dem Entfernen der Maske erfolgt eine Implantation eines Dotierstoffs zur Erzeugung der Gebiete 2 und 3, wobei die Schichten 5, 7 und 8 sowie die Feldoxidschicht als Teile einer Dotierungsmaske dienen (Selbstjustierung). Nach dem Anbringen der Anschlußleitungen 10 und 26, die die Teile 2 und 3 durch Kontaktlöcher in der Isolatorschicht 6 kontaktieren, werden schließlich oberhalb der Gebiete 2 und 3 die vorher weggeätzten Teile der Feldoxidschicht wieder so weit aufgebaut, daß die Feldoxidschicht an die lateralen Begrenzungsflächen der Schichten 5, 7 und 8 heranreicht, wie das in Fig. 1 durch die Teile 9 angedeutet ist. Danach wird die Ánschlußleitung 15 verlegt, die die Schicht 8 kontaktiert.

Die Herstellung des Halbleiter-Bauelements nach Fig.3 unterscheidet sich hiervon lediglich dadurch, daß die Isolatorschicht 6 zunächst mit einer Dicke von etwa 20 nm aufgewachsen wird, die dem Teil 6a entspricht. Danach wird eine Zwischenmaske auf der Isolatorschicht angebracht, die mit ihrer Öffnung lediglich den Bereich der metallisch leitenden Schicht 5 freiläßt. In diesem Bereich wird dann die Isolatorschicht, z.B. durch ein Ätzmittel auf Fluor-Wasserstoff-Basis, auf eine Dicke von etwa 2 bis 5 nm abgeätzt, was in Fig. 3 durch die reduzierte Dicke der Schicht 6 oberhalb von 4a angedeutet ist. Unter Verwendung derselben Zwischenmaske wird dann die Schicht 5 aufgebracht. Nach dem Entfernen der Zwischenmaske wird sodann die bereits genannte, mit ihrer Öffnung die lateralen Abmessungen der Schichten 7 und 8 definierende Maske aufgebracht. Die weiteren Herstellungsschritte, beginnend mit dem Aufbringen der Isolatorschicht 7 und der Schicht 8, entsprechen dem bereits in Verbindung mit dem Halbleiter-Bauelement nach Fig. 1 erläuterten Verfahren.

Eine andere bevorzugte Ausführungsform der Erfindung weist einen Körper 1 aus einer p-dotierten III-V-Halbleiterverbindung, z.B. GaAs, mit einer Dotierungskonzentration von z.B. $10^{16}$/cm$^3$ auf, wobei die Isolatorschicht 6 zweckmäßigerweise aus AlGaAs besteht. Die zweite Isolatorschicht 7 besteht dann vorzugsweise ebenfalls aus AsGaAs. Die Schicht 5 wird vorzugsweise aus einer hochdotierten n-leitenden III-V-Halbleiterverbindung, wie z.B. GaAs mit Si als Dotierstoff, gebildet, die sich bei einer Dotierungskonzentration von etwa $10^{18}$/cm$^3$ hinsichtlich ihrer elektrischen Leitfähigkeit ähnlich wie ein Metall verhält. Die Schicht 8 besteht auch hierbei mit Vorteil aus dem gleichen Material wie die Schicht 5 und weist die gleiche Dotierung auf. Bei der Herstellung dieser Ausführungsform wird zum Aufbringen der einzelnen Schichten 6, 5, 7 und 8 zweckmäßigerweise die Molekularstrahlepitaxie (molekular beam epitaxy - MBE) verwendet.

20 Patentansprüche
 3 Figuren

## Patentansprüche

1. Halbleiter-Bauelement mit einem Heiße-Elektronen-Transistor des Tunnelemissionstyps, der eine Emitterschicht, eine erste Isolatorschicht (6), eine Basisschicht (5) und eine Kollektorschicht (7, 8) aufweist und der mit einer Basis-Emitter-Spannungsquelle (12) versehen ist, d a d u r c h  g e k e n n z e i c h - n e t , daß die Emitterschicht aus einer Inversionsschicht (16) besteht, die im Kanalbereich (4) eines auf einem Halbleiterkörper (1) integrierten Feldeffekttransistors zwischen dessen Source- und Draingebiet (1, 2) aufgebaut ist, daß die Basisschicht (5) wenigstens einen Teil der Gateelektrode des Feldeffekttransistors darstellt, daß die erste Isolatorschicht (6) zwischen der Basisschicht (5) und einer Grenzfläche (1a) des Halbleiterkörpers (1) angeordnet ist und daß die Kollektorschicht aus einer metallischen oder metallisch leitenden Schicht (8) und einer zwischen dieser und der Basisschicht (5) befindlichen, zweiten Isolatorschicht (7) besteht.

2. Halbleiter-Bauelement nach Anspruch 1, d a d u r c h  g e k e n n z e i c h n e t , daß die Basisschicht (5) einen ersten Teil der Gateelektrode darstellt, wobei der von diesem überdeckte, erste Teil (4a) des Kanalbereichs (4) an das Sourcegebiet (2) angrenzt und eine erste Einsatzspannung aufweist, und daß ein die Basisschicht (5) lateral überragender Teil der Kollektorschicht (8) den restlichen Teil der Gateelektrode bildet, wobei der von diesem überdeckte, restliche Teil (4b) des Kanalbereichs (4) eine zweite Einsatzspannung aufweist, die größer ist als die erste.

3. Halbleiter-Bauelement nach einem der ansprüche 1 oder 2, d a d u r c h   g e k e n n z e i c h n e t , daß die erste Isolatorschicht (6) aus $SiO_2$ oder $Si_3N_4$ besteht.

4. Halbleiter-Bauelement nach einem der Ansprüche 1 oder 2, d a d u r c h   g e k e n n z e i c h n e t , daß die erste Isolatorschicht (6) aus AlGaAs besteht.

5. Halbleiter-Bauelement nach einem der Ansprüche 1 bis 3, d a d u r c h   g e k e n n z e i c h n e t , daß die Basisschicht (5) aus einem Metall besteht, das insbesondere einer Gruppe von hochschmelzenden Metallen angehört, in der Ta, Ti, Mo und W enthalten sind, oder aus einem Silizid eines solchen Metalls.

6. Halbleiter-Bauelement nach Anspruch 1 oder 2, d a - d u r c h   g e k e n n z e i c h n e t , daß die Basisschicht (5) aus einer hochdotierten III-V-Halbleiterverbindung, wie z.B. GaAs, besteht, die mit einer n-Dotierung versehen ist.

7. Halbleiter-Bauelement nach einem der Ansprüche 1 oder 2, d a d u r c h   g e k e n n z e i c h n e t , daß die zweite Isolatorschicht (7) aus $SiO_2$ oder $Si_3N_4$ besteht.

8. Halbleiter-Bauelement nach Anspruch 1 oder 2, d a - d u r c h   g e k e n n z e i c h n e t , daß die zweite Isolatorschicht (7) aus AlGaAs besteht.

9. Halbleiter-Bauelement nach Anspruch 1 oder 2, d a - d u r c h   g e k e n n z e i c h n e t , daß die einen Teil der Kollektorschicht darstellende metallische oder metallisch leitende Schicht (8) aus einem Metall besteht, das insbesondere einer Gruppe von hochschmelzenden Metal-

0141088

len angehört, in der Ta, Ti, Mo und W enthalten sind, oder aus einem Silizid eines solchen Metalls.

10. Halbleiter-Bauelement nach Anspruch 1 oder 2, d a d u r c h  g e k e n n z e i c h n e t , daß die einen Teil der Kollektorschicht dastellende metallische oder metallisch leitende Schicht (8) aus einer hochdotierten III-V-Halbleiterverbindung, wie z.B. GaAs, besteht, die mit einer n-Dotierung versehen ist.

11. Halbleiter-Bauelement nach einem der Ansprüche 1 bis 10, d a d u r c h  g e k e n n z e i c h n e t , daß die erste Isolatorschicht (6) eine Dicke von etwa 2 bis 5 nm hat.

12. Halbleiter-Bauelement nach einem der Ansprüche 1 bis 11, d a d u r c h  g e k e n n z e i c h n e t , daß die Basisschicht (5) eine Dicke von etwa 10 nm hat.

13. Halbleiter-Bauelement nach Anspruch 7, d a d u r c h  g e k e n n z e i c h n e t , daß die zweite Isolatorschicht (7) eine Dicke von etwa 2 bis 5 nm hat.

14. Halbleiter-BAuelement nach Anspruch 1, d a d u r c h  g e k e n n z e i c h n e t , daß in einer Kollektoranschlußleitung (15) eine Kollektorspannungsquelle (13) in Serie zu einem Lastwiderstand ($R_{L1}$) vorgesehen ist.

15. Halbleiter-Bauelement nach Anspruch 14, d a d u r c h  g e k e n n z e i c h n e t , daß die Kollektorspannungsquelle (13) an das Draingebiet (3) angeschlossen ist und als Source-Drain-Spannungsquelle des Feldeffekttransistors dient.

0141088

16. Verfahren zum Betrieb eines Halbleiter-Bauelements nach einem der Ansprüche 1 bis 15, d a d u r c h g e k e n n z e i c h n e t , daß die von der Basis-Emitter-Spannungsquelle (12) abgegebene Spannung zwischen zwei Werten umgeschaltet wird und daß bei einer Umschaltung auf den größeren Wert, der oberhalb einer ersten Einsatzspannung liegt, die dem von der Basisschicht als Gateelektrode überdeckten Teil (4a) des Kanalbereichs zugeordnet ist, die Isolatorschicht (6) von einem Tunnelstrom durchflossen wird, der an einem in einer Kollektoranschlußleitung (15) liegenden Lastwiderstand ($R_{L1}$) eine abgreifbare Spannung hervorruft, während die Umschaltung auf den kleineren Wert eine wesentliche Verkleinerung oder Abschaltung dieser Spannung zur Folge hat.

17. Verfahren zum Betrieb eines Halbleiter-Bauelements nach einem der Ansprüche 1 bis 15, d a d u r c h g e k e n n z e i c h n e t , daß die von der Basis-Emitter-Spannungsquelle (12) abgegebene Spannung auf einen Wert eingestellt wird, der oberhalb der ersten Einsatzspannung liegt, die dem von der Basisschicht als Gateelektrode überdeckten Teil (4a) des Kanalbereichs zugeordnet ist, daß die abgegebene Spannung von diesem Wert ausgehend in Abhängigkeit von einem Eingangssignal verändert wird, so daß ein die erste Isolatorschicht (6) durchfließender Tunnelstrom entsprechende Änderungen erfährt, und daß an einem in einer Kollektoranschlußleitung (15) liegenden Lastwiderstand ($R_{L1}$) eine Spannung abgegriffen wird, die von den Änderungen des Eingangssignals abhängige, gegenüber diesen verstärkte Änderungen aufweist.

18. Verfahren zum Betrieb eines Halbleiter-Bauelements nach einem der Ansprüche 2 bis 15, d a d u r c h g e k e n n z e i c h n e t , daß die Basis-Emitter-Spannungsquelle (12) einen festen Spannungswert abgibt, daß eine von einer Kollektorspannungsquelle (13) abgegebene Spannung zwischen zwei Werten umgeschaltet wird, und daß bei einer Umschaltung auf den größeren Wert der Basisschicht (5) eine Gatespannung zugeführt wird, die oberhalb einer ersten Einsatzspannung liegt, die dem von der Basisschicht (5) als Gateelektrode überdeckten Teil (4a) des Kanalbereichs zugeordnet ist, wobei die Isolatorschicht (6) von einem Tunnelstrom durchflossen wird, der an einem in einer Kollektoranschlußleitung (15) liegenden Lastwiderstand ($R_{L1}$) eine abgreifbare Spannung hervorruft, während eine Umschaltung auf den kleineren Wert eine wesentliche Verkleinerung oder Abschaltung dieser Spannung zur Folge hat.

19. Verfahren zum Betrieb eines Halbleiter-Bauelements nach einem der Ansprüche 2 bis 15, d a d u r c h g e k e n n z e i c h n e t , daß die Basis-Emitter-Spannungsquelle (12) einen festen Spannungswert abgibt, daß eine von einer Kollektorspannungsquelle (13) abgegebene Spannung auf einen Wert eingestellt wird, bei dem der Basisschicht (5) eine Gatespannung zugeführt wird, die oberhalb einer ersten Einsatzspannung liegt, die dem von der Basisschicht (5) als Gateelektrode überdeckten Teil (4a) des Kanalgebiets zugeordnet ist, daß die von der Kollektorspannungsquelle (13) abgegebene Spannung von dem festen Spannungswert ausgehend in Abhängigkeit von einem Eingangssignal verändert wird, so daß ein die Isolatorschicht (6) durchfließender Tunnelstrom entsprechende Änderungen erfährt, und daß an einem in einer Kollektoranschlußleitung liegenden Lastwiderstand ($R_{L1}$) eine Spannung abgegriffen wird, die von den Änderungen des Eingangssignals abhängige, gegenüber diesen verstärkte Änderungen aufweist.

83 P 1 6 0 9 E **0141088**

20. Verfahren zum Betrieb eines Halbleiter-Bauelements nach einem der Ansprüche 2 bis 15, d a d u r c h g e k e n n z e i c h n e t , daß die von der Kollektorspannungsquelle (13) abgegebene Spannung zwischen zwei Werten umgeschaltet wird, von denen der erste an der den restlichen Teil der Gateelektrode bildenden Teil der Kollektorschicht eine Gatespannung hervorruft, die unterhalb der dem restlichen Teil (4b) des Kanalbereichs zugeordnenten zweiten Einsatzspannung liegt, während der zweite an diesem Teil der Kollektorschicht eine Gatespannung hervorruft, die oberhalb der zweiten Einsatzspannung liegt, und daß bei einer Umschaltung auf den zweiten Wert ein Strom zwischen dem Sourcegebiet (2) und dem Draingebiet (3) fließt, der an einem Lastwiderstand $(R_L)$ des Feldeffekttransistors eine abgreifbare Spannung bzw. Spannungsänderung hervorruft, während eine Umschaltung auf den ersten Wert zu einer Abschaltung der letzteren führt.

# FIG 1

# FIG 2

0141088

# FIG 3